# EUROPEAN PATENT SPECIFICATION

(11) **EP 0 877 100 B1**
(45) Date of publication and mention of the grant of the patent: **20.06.2001**
(21) Application number: 98303376.2
(22) Date of filing: 30.04.1998
(51) Int. Cl.: C23C 18/12, H01L 21/316, C04B 35/495

(54) **Process for fabricating solid-solution of layered perovskite materials**
Verfahren zur Herstellung von festen Lösungen von schichtförmigen Perovskit-Materialien
Procédé de fabrication de solutions solides de matériaux de perovskite en couches

(30) Priority: 06.05.1997 US 852253
(43) Date of publication of application: 11.11.1998
(73) Proprietor: Sharp Kabushiki Kaisha, Osaka-shi, Osaka 545-8522 (JP); VIRGINIA TECH INTELLECTUAL PROPERTIES, INC., Blacksburg Virginia 24060 (US)
(72) Inventor: Desu, Seshu B., Blacksburg, VA 24061-0237 (US); Joshi, Pooran C., Blacksburg, VA 24061-0237 (US); Zhang, Xubai, Blacksburg, VA 24061-0237 (US); Ryu, Sang O., Blacksburg, VA 24061-0237 (US)
(74) Representative: West, Alan Harry

(56) References cited:
- US-A- 5 423 285
- US-A- 5 468 679
- US-A- 5 508 226

## Description

This invention relates generally to the use of solid solution of layered perovskite materials, particularly, e.g. (1-x)SrBi₂Ta₂O₉-xBi₃Ti(Ta_{1-y}Nb_{y})O₉, for nonvolatile random access memory and integrated electronic applications and describes a simple method of fabricating the films of these materials using chemical precursor solution prepared under room temperature conditions.

Ferroelectric thin films have attracted considerable attention for their potential applications in nonvolatile random access memory (NVRAM) and dynamic random access memory (DRAM) devices (see J. F. Scott et al., "Ferroelectric Memories", Science, 1989). The basic characteristics of a ferroelectric material that make it suitable for memory device application are its ability to retain two stable remanent polarization (± Pᵣ) values at zero field, thus providing nonvolatility, and the polarization reversal from one stable polarization state to another under the application of an electric field. Desired properties of ferroelectric thin films for memory applications include high polarization value, a small difference between saturation polarization (Pₛ) and remanent polarization (Pᵣ), a low coercive field (E_{c}), and most importantly, the films must be highly durable so that they are capable of sustaining a high number of switching reversals. Additionally, to be useful, a ferroelectric material in a memory array must have good retention and imprint characteristics. The films must have very uniform composition and thickness over the surface of the integrated circuit (IC) so that the capacitance associated with each memory cell is the same. Also, the processing required to produce the ferroelectric thin film must not have a detrimental effect on the underlying circuitry.

Many materials show ferroelectricity and two families of materials, perovskites (i.e. PbZr₁₋ₓTiₓO₃) and layered perovskites (i.e. SrBi₂Ta₂O₉ and SrBi₂Nb₂O₉), have been widely investigated for memory applications. The parameters of importance for applications in memories are switching polarization, fatigue, polarization retention, imprint, and leakage current characteristics.

The realization of a commercially viable nonvolatile FRAM technology based on PZT has been hampered by one or the combination of the problems related to either the reliable performance of the PZT ferroelectric capacitor or to the growth and processing of ferroelectric capacitor layers. The PZT films grown on metal electrodes such as Pt show high fatigue, i.e. loss of polarization with switching cycles. The polarization fatigue problem can be solved for all practical purposes only by replacing the metallic Pt electrodes with metal-oxide electrodes such as RuO₂, or with any of the perovskite metal oxides such as La_{0.5}Sr_{0.5}CoO₃, or with hybrid metal-oxide electrodes, among others. The lead based ferroelectrics have been extensively studied, but recently issues with fatigue, environmental safety, and health concerns have prompted interest in SrBi₂Ta₂O₉ (SBT) which belongs to the layered perovskite family. The layered perovskite materials are attractive because of their good fatigue, retention, and electrical characteristics. SBT is a promising material for memory applications because of its low leakage current and good fatigue and retention characteristics. The major limitation for the application of the SBT material is the high processing temperature (800-850 °C), lower Pₙ and low Curie temperature which make the direct integration into high density CMOS devices extremely difficult. The major points of comparison (advantages and disadvantages) between the PZT and SBT based capacitor technologies are:
- PZT based capacitors have larger polarization (40-50 µC/cm²) than the polycrystalline SBT-based capacitors (∼20 µC/cm²) hitherto developed.
- PZT layers with a pure perovskite structure and good electrical properties can be generally produces at lower temperatures (600-700 °C) than SBT layers (750-850 °C) depending on the particular film deposition technique.
- PZT based capacitors require oxide or hybrid-metal-oxide electrodes technology to yield negligible fatigue and imprint-two important electrical properties for FRAMs. These electrodes are more complicated to synthesize than pure metal electrodes such as Pt.
- PZT based capacitors involve Pb, which may present contamination and hazardous problems during fabrication.
- SBT based capacitors present negligible fatigue and imprint using the simpler Pt electrode technology.
- SBT layers maintain good electrical properties even when they are very thin (<100 nm).

The major problems to overcome for the realization of a practical high density memory device are:
- SBT based capacitors have lower polarization than PZT based capacitors. Intrinsic high polarization values may be necessary when scaling capacitors to the submicron dimensions needed for these memories. This may be a problem in relation to the application of SBT to high-density memories.
- The synthesis of SBT layers with the appropriate layered perovskite structure requires high temperature (800-850 °C) depending on the film deposition technique. The processing temperatures are high in relation to standard semiconductor device processing temperatures, and therefore efforts are warranted to reduce it.
- The Curie temperature of SBT is low (∼310 °C). A higher Curie temperature is desired for memory applications as the ferroelectric properties are strongly dependent on the Curie temperature. As the operating temperature approaches the Curie temperature the ferroelectric polarization decreases rapidly. So the Curie temperature is required to be much higher than the operating temperature range to ensure a stable constant polarization.

The article "A Family of Ferroelectric Bismuth Compounds" by E.C. Subbarao (J. Phys. Chem. Solids, Vol. 23, pp. 665-676 (1962)) describes a material having composition SᵣBi₂ N₆₂O₉-Bi₃ TiNbO₉. The above article describes the bulk material but not properties or applications thereof, and does not describe or suggest the compounds on film forming methods as further described herein. U.S. Pat. No. 5,423,285 (Araujo et al., 1993) describes certain aspects of fabrication of layered perovskite materials. However, it does not describe or suggest the formation or use of solid-solutions as further described herein. The compounds of Araujo et al. have inferior ferroelectric properties compared to those of the present invention at annealing temperatures of 750 °C. Moreover, the present invention provides relatively good ferroelectric properties of annealing temperatures of 650 °C or lower. Additionally, the methods of the present invention allow a precursor solution to be prepared at ambient (such as less than about 35°C) temperatures. This alone is a notable advance in the art, as comparable methods known to the applicant (such as Araujo et al.) require precursor heating at elevated temperatures, such as over 70°C or higher.

The final quality of the ferroelectric thin film depends on the intrinsic property of the material, processing technique, annealing treatment, and extrinsic factors such as substrate and electrodes. SBT is the most promising material at present. However, the SBT based capacitor technology has to overcome the problems of high processing temperature, low remanent polarization, and low Curie temperature.

In accordance with the present invention, there is now provided a method of forming a film of layered perovskite material, comprising the steps of
(a) dissolving bismuth 2-ethylhexanoate in a first solvent to form a first solution;
(b) dissolving strontium acetate in a second solvent to form a second solution;
(c) dissolving titanium isopropoxide and tantalum ethoxide in a third solvent to form a third solution;
(d) mixing together the solutions formed in steps (a), (b) and (c) to form a homogenous mixed solution, steps of (a), (b), (c) and (d) being carried out at ambient temperature; and
(e) depositing the homogenous mixed solution onto a substrate, thereby to form a film of (1-x)SrBi₂TaO₉-xBi₃TiTaO₉.

In a preferred and modified method of the invention, step (c) comprises dissolving titanium isopropoxide, tantalum ethoxide and niobium ethoxide in a third solvent to form a third solution and step (e) comprises depositing the homogenous mixed solution onto a substrate thereby to form a film of (1-x)SrBi₂Ta₂O₉-xBi₃TiNbO₉.

This invention solves the above problems by using a new solid solution material which shows excellent properties. The method of the invention makes use of a room temperature chemical precursor solution preparation technique developed to process high quality pyrochlore free crystalline films at a low post-deposition annealing temperature of 650°C. The line of approach and considerations in selecting the proposed new solid solution material and the modified chemical preparation technique to overcome the problems with SBT based capacitor technology have been the following:
- SBT layers with an appropriate layered perovskite structure require high temperatures (800-850°C) depending on the film deposition technique. At lower temperatures the films exhibit poor microstructural and ferroelectric properties. The polycrystalline nature of the SBT layers in conjunction with the polarization direction of the SBT material may contribute to this effect. Intrinsic high polarization values may be necessary when scaling capacitors to the submicron dimensions needed for these memories. The idea of solid solution material to overcome these problems is based on the bulk ceramic approach where the properties of a material are modified by making a solid solution with a material having different micro structural and Curie temperature characteristics but similar structure (see E. C. Subbarao, supra). SBT has a curie temperature of 310°C while the Bi₃TiTa_{1-y}Nb_{y}O₉ has Curie temperature in the range 870-950 °C. Both of these materials belong to the layered perovskite family. So the solid solution of these two materials is expected to exhibit a higher Curie temperature.
- For bulk SBT material a saturation polarization (Pₛ) of 5.8 µC/cm² has been reported while a Pₛ value of 27.7 µC/cm² has been reported for Bi₃TiNbO₉ material. So the solid solution is expected to show a higher polarization value compared to SBT.•It is not possible to reduce the post-deposition annealing temperature due to poor ferroelectric properties at lower annealing temperatures. This problem is intrinsic in nature and is due to small grain sizes at lower annealing temperatures. The Bi₃TiTa_{1-y}Nb_{y}O₉ material shows a much larger grain structure compared to SBT under similar annealing conditions. So the solid solution is expected to yield larger grain sizes at lower annealing temperature compared to SBT and hence solve the problem of reducing the processing temperature.

The same idea can also be applied for the fabrication of other solid solution materials. The solid solutions of layered perovskite materials can be made among the materials which can be classified under three general types (see G. A. Smolenskii et al., "Ferroelectrics and related materials", Gordon and Breach Science Publishers, New York, 1984):
1. Compounds having the formula Aₘ₋₁Bi₂MₘO₃ₘ₊₃, where A= Bi³⁺, Ba²⁺, Sr²⁺, Ca²⁺, Pb²⁺ ,K⁺, Na⁺, and other ions of comparable size, and M= Ti⁴⁺, Nb⁵⁺, Ta⁵⁺, Mo⁶⁺, W⁶⁺, Fe³⁺, and other ions that occupy oxygen octahedra, including compounds such as Bi₄Ti₃O₁₂, SrBi₂Ta₂O₉.
2. Compounds having the formula Aₘ₊₁MₘO₃ₘ₊₁, including compounds such as strontium titanates Sr₂TiO₄, Sr₃Ti₂O₇, Sr₄Ti₃O₁₀.
3. Compounds having the formula AₘMₘO₃ₘ₊₁ including compounds such as Sr₂Nb₂O₇, La₂Ti₂O₇.

These layered perovskite materials comprise complex oxides of metals, such as strontium, calcium, barium, bismuth, cadmium, lead, titanium, tantalum, hafnium, tungsten, niobium, zirconium, scandium, yttrium, lanthanum, antimony, chromium, and thallium that spontaneously form layered perovskite structure. Generally, each layered perovskite material will include two or more of the above metals. When the material includes elements like lead, bismuth, thallium, and/or antimony, that evaporate or otherwise are lost in the process, an excess amount in the range 1-100 % can be used to achieve the optimum properties. These solid solution materials can also be doped to modify the properties for various electronic applications. This invention provides a simple room temperature chemical precursor solution preparation technique for the fabrication of pyrochlore-free crystalline films at low annealing temperatures. The chemical precursor solution technique using a carboxylate-alkoxide combination according to the invention provides a pyrochlore free crystalline phase even at low annealing temperatures. The main features of the process are room temperature preparation, short preparation time, easy availability of precursors, stability, and compatibility with semiconductor-fabrication technology. A rapid fabrication process is desirable, since long processes are more expensive in terms of the use of the facilities and personnel. The present process is used for the fabrication of layered perovskites.

The process is simple and compatible with conventional integrated circuit materials and processes. The process starts with preparing a precursor solution containing each of the metals in the desired thin film compound. There are three general methods for the preparation of precursor solution for the fabrication of oxide thin films: (1) All alkoxide method, (2) Alkoxide-salt method, (3) other methods. An oxide network is formed in these techniques via hydrolysis and condensation of molecular precursors. This chemistry is controlled by parameters such as the hydrolysis ratio, catalysis or molecular structure of precursors. This latter can be simply modified by oligomerization, solvation or addition of nucleophilic chemical additives such as organic acids, β-diketones or allied derivatives which lead to the tailoring of the coordination shell of the metal. The selection of precursor compounds and the solvents is the most important step in the precursor solution approach for the fabrication of thin films. The most important points to be taken into consideration are: nature of initial species, formation of mixed metal species or not?, the stoichiometry of the various elements in the solution with respect to the formulation required, influence of the solvent, the temperature of the reaction and its effect on the homogeneity at a molecular level, elimination of organics from the deposited film, and temperature of crystallization. The first step in the all-alkoxide method is the selection of alkoxides for each element of the desired composition and then the synthesis of a solution containing the requisite metal cations. Commonly, the solution is comprised of metal alkoxides [M(OR)ₓ] in an alcohol solvent. Addition of water to an alkoxide solution results in hydrolysis followed by condensation reactions, network formation, and the eventual development of a continuous polymeric gel. While many alkoxides have been synthesized and used successfully in thin film processing, some metal alkoxides have low solubility, are difficult to prepare, and are not stable over time Most metal alkoxides are very reactive towards hydrolysis and condensation. Consequently, the exclusive use of alkoxides for multicomponent solutions is sometimes not possible, and often alternative precursors are necessary. Most advanced ceramics are multicomponent materials having two or more types of cations in the lattice. Since alkoxide precursors are mixed at the molecular level in the solution, a high degree of homogeneity is expected. However, a major problem in forming homogeneous multicomponent solution is the unequal hydrolysis and condensation rates of the metal alkoxides. This may result in phase separation, during hydrolysis or thermal treatment, leading to higher crystallization temperatures or even undesired crystalline phases. It is therefore necessary to prepare solutions of high homogeneity in which cations of different types are uniformly distributed at an atomic scale through M-O-M' bridges. The initial solution should therefore be treated such that bonds are first formed between the various alkoxide precursors prior to gelation. A difficulty of the all-alkoxide approach, especially of soluble alkoxides are concerned, is to apprehend the formation or not of the mixed-metal species and the stoichiometry between the metals. Solubilization of one metal alkoxide in the presence of another is a criterion to be handled with care since it does not necessarily imply the formation of a mixed-metal species and thus homogeneity at a molecular level. There is for instance no reaction between bismuth and titanium 2-methoxyethoxides (IR and ¹H NMR evidence) despite the formation of a homogeneous solution. For compounds containing bismuth as an element, the selection of precursor is a problem because of the lack of reactivity of bismuth alkoxides. The bismuth alkoxide, Bi(OR)₃ R=Et, iPr, has been found to show lack of reactivity towards a variety of metal alkoxides including niobium, tantalum, titanium, and lead.

The alkoxide-salt approach can overcome many of these problems with all-alkoxide method. The term salt for the described process basically refers to carboxylates but also includes the use of nitrates, sulfates, carbonates, chlorides, and hydroxides. The alkoxides and the carboxylates fall in the group of organic derivatives of metals with metal-oxygen-carbon bonds. The alkoxide-salt approach overcomes many problems with the all-alkoxide approach as for some elements of the desired composition, a salt can be selected as precursor instead of alkoxide. For most metals, a metal carboxylate with medium length ligands is the preferred precursor compound. The carboxylate anions (general formula, RCOO⁻) are versatile ligands capable of (1) existing simply as counter anions, or (2) binding the metals in (a) unidentate, (b) chelating, or (c) bridging modes. The wide variety of available groups (e.g. R may be H, alkyl, aryl, perfluoroalkyl, etc.) greatly enhance the versatility of carboxylate ligands. The metal carboxylates have the important feature of forming metal-metal bond. A metal acetate or 2 ethylhexanoate precursor works for most metals. They behave as active metal oxide sources and are involved in reactions with metal alkoxides. Acetates based on di and trivalent metals show high reactivity towards metal alkoxides and are easily incorporated in mixed metal species often-in quiet mild conditions. For example, acetates based on magnesium, cadmium, barium, strontium, and lead undergo dissolution and incorporation in mixed-metal-species under room temperature conditions. The choice of solvent is also important in alkoxide-salt approach. The influence of the solvent can be multiple: it can generate and/or stabilize intermediates and thus allow, preclude or modify reactions. The presence of alcohol helps in the formation of reactive species. The main advantage of the alkoxide-carboxylate approach is that the side product in the reaction is comparatively non reactive compared to H₂O in the all-alkoxide approach. In all acetatoalkoxides, the carboxylate ligand is in bridging position and holds the different metals together. The acetatoalkoxides appear generally more soluble than simple alkoxides especially in the parent alcohol. Most metal alkoxides are very reactive towards hydrolysis and condensation. They must be stabilized to avoid precipitation. These reactions are controlled by adding complexing agents that react with metal alkoxides at a molecular level, giving rise to new molecular precursors of different structure, reactivity, anc functionality. The carboxylic acids, such as acetic acid, and β-diketones, mainly acetylacetone, which act as hydroxylated nucleophilic ligands, help in controlling the hydrolysis rates by decreasing the functionality of the precursor. The reaction betweet alkoxide and carboxylate in the presence of alcohols and carboxylic acids proceeds with the formation of smallest possible aggregate which allows the metals to achieve thei most usual coordination number, and thus hydrolysis becomes more difficult Carboxylates act as assembling and oxo donor ligands, and thus have a tendency increase the nuclearity of the aggregates; diketones are chelating ligands and thus decreas the oligomerization.

The invention is described below in greater detail by way of example only with reference to the accompanying drawings, in which :
Fig. 1. Flow diagram for the fabrication of layered perovskite materials and their solid solutions by the chemical precursor solution technique using alkoxide-salt precursor solution prepared under room temperature conditions;
Fig. 2. XRD patterns of SrBi₂Ta₂O₉ thin films as a function of annealing temperature;
Fig. 3. Atomic Force Micrographs of SrBi₂Ta₂O₉ thin films annealed at 750 °C;
Fig. 4. Typical P-E hysteresis loop for SrBi₂Ta₂O₉ thin film;
Fig. 5. Decay of polarization for SrBi₂Ta₂O₉ thin films as a function of number of switching cycles;
Fig. 6. XRD patterns of 0.7SrBi₂Ta₂O₉-0.3Bi₃TiTaO₉ thin films as a function of annealing temperature;
Fig. 7. Atomic Force Micrographs of 0.7SrBi₂Ta₂O₉-0.3Bi₃TiTaO₉ thin films annealed at 750°C;
Fig. 8. Typical P-E hysteresis loop for 0.7SrBi₂Ta₂O₉-0.3Bi₃TiTaO₉ thin film;
Fig. 9. Decay of polarization for 0.7SrBi₂Ta₂O₉-0.3Bi₃TiTaO₉ thin films as a function of number of switching cycles;
Fig.10. XRD patterns of 0.8SrBi₂Ta₂O₉-0.2Bi₃TiNbO₉ thin films as a function of annealing temperature ;
Fig. 11. Atomic Force Micrographs of 0.8SrBi₂Ta₂O₉-0.2Bi₃TiNbO₉ thin films annealed at 750 °C;
Fig. 12. Typical P-E hysteresis loop for 0.8SrBi₂Ta₂O₉-0.2Bi₃TiNbO₉ thin film; and
Fig. 13. Decay of polarization for 0.8SrBi₂Ta₂O₉-0.2Bi₃TiNbO₉ thin films as a function of number of switching cycles.

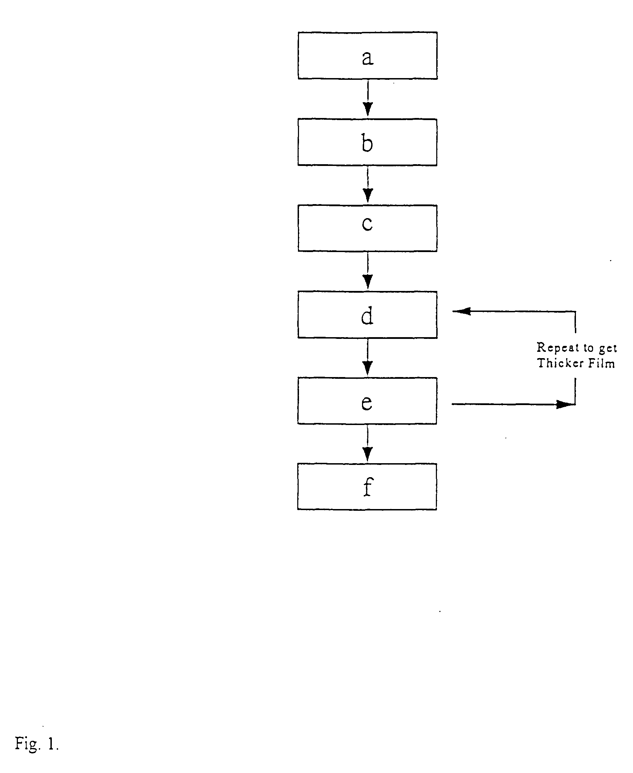

Referring to the drawings, Figure 1 shows the general steps in the fabrication of films by the technique described in this invention. The first steps, steps a b and c involve the selection of precursor compounds and the solvents. The selection of precursor compounds and the solvents is an important step in the preparation of thin films by chemical technique using precursor solution. The precursors for individual metal should have a long shelf life. The selected precursors should have high solubility in the selected solvents and the various solvents should be compatible when mixed. The final precursor solution should have a relatively long shelf life so that it can be made ahead of time in volume and used as needed. The various steps in the alkoxide-salt approach are :
1. The selection of metal alkoxides or carboxylates as the starting precursors. The precursor should be one in which the organic groups forming the ligands which hold the metals of the future film are relatively small so as to minimize the amount of organic material that has to be vaporized, and thus minimize the size of the pores and other microscopic defects in the film. Short chain metal carboxylates are also usually very polar and are therefore very water soluble, thus they do not separate when hydrolysis water is added to the solution. However, the high polarity also tends to make them insoluble in high boiling point solvents such as xylenes and 2-methoxyethanol. On the other hand, the longer-chain metal carboxylates, such as neodeconates and 2-ethylhexanoates are generally all soluble in either 2-methoxyethanol or xylenes. However, they are not soluble in water. Thus the presence of any substantial amount of a metal neodeconate or a metal 2-ethylhexanoate usually will cause separation of the hydrolysis water and gelation of the alkoxide around the water droplets formed if hydrolysis is attempted. Furthermore, longer chain materials contain too much organic material to produce good films. So the metal carboxylates with intermediate length ligands, having approximately ten or less carbon links in their chains, will be more suitable for the preparation of a precursor solution with longer shelf life and also for fabricating high quality thin films. Preferably the metal carboxylate is a metal carboxylate having up to a medium chain ligand, such as metal acetates and metal 2-ethylhexanoates. These are available for most of the metals.
2. A carboxylic acid can be selected as solvent for metal carboxylates. Preferably the boiling point of the solvent should be greater than 100 °C and in the range 100-250 °C. The preferred solvents for the alkoxide-salt precursors are alcohols, aromatic hydrocarbons, ketones, esters, ethers, and alkanolamines A single solvent or a combination of solvents can be used to optimize the solubility and viscosity to obtain high quality coatings.

The procedure then consists of dissolving the individual precursors in the selected solvents and step d. involves the mixing of these solutions get a final homogeneous solution. In this step, the hydrolysis and polycondensation of the final solution is controlled to stabilize the final solution. This is usually performed with carboxylic acids, β-diketones, alcoholysis, and/or hydrolysis. The next step, e, is the deposition of the precursor solution on a substrate. The films can be prepared from the precursor solution using spin, dip, or spray technique. Alcoholic solutions are generally capable of wetting all metal substrates, oxide substrates or metal-semiconductor substrates with a thin oxide layer on the surface. Almost any substrate that will support a thin film and is compatible with the materials and processes may be used. In the present case the thin films were prepared by using spin-coating technique, which is a well known form of deposition in which the precursor is placed on a wafer and the wafer is spun to evenly distribute the precursor over the wafer. The spinning speed and the viscosity of the solutions need to be optimized to control the thickness of the films. Preferably, the wafer is spun at a spin rate of between 1000 rpm and 7000 rpm for a period of 5 seconds to 120 seconds. The film first produced on the substrate in step e is a wet film. The film is then baked for removal of organic content. After the coating process, the wafer is transferred to a hot plate on which it is baked. Alternatively, an oven may be used in baking if it is desirable to control ambients. Preferably, the baking is at a temperature in the range 150-350 °C for a time period between 1-15 minutes. Optionally, a drying step may be performed between the coating and the bake steps. Preferably, the drying is performed between the temperature range 150-200 °C. If the desired thickness is not obtained in single coating, then the spin, dry, and bake processes, step e, are repeated till the desired thickness is achieved. Finally (step f) after the last layer is coated and baked, the film is annealed in a diffusion furnace or in a rapid thermal annealing system. The annealing is preferably done at different temperatures for different times in an oxygen atmosphere at different flow rates. Depending on the type of substrate and the processing procedure, crystalline films with different morphologies can be obtained. The most common product is polycrystalline film with no apparent preferred crystallographic orientations. Polycrystalline films are usually obtained when any one of the following substrate type is used: polycrystalline substrates, amorphous substrates, and single-crystal substrates with large lattice mismatch. Texture-oriented films may be obtained under several special conditions. First, when single-crystal substrates with fairly large lattice mismatch are used, the film grown over the surface may be highly preferentially oriented. Alternatively, the films can be grown with a preferred orientation if a small dc bias field is applied along the substrate surface during the post-deposition annealing treatment. The films annealed using rapid thermal annealing process also show preferred orientation for some cases. When single-crystal substrates with a small lattice mismatch are used, epitaxial films can be formed for some ferroelectric systems.

The following Examples illustrate the invention.

### EXAMPLE 1

### Strontium Bismuth Tantalate- SrBi₂Ta₂O₉

This Example serves to illustrate the principles embodied in the method of the invention, which is fully illustrated in Examples 2 and 3 below.

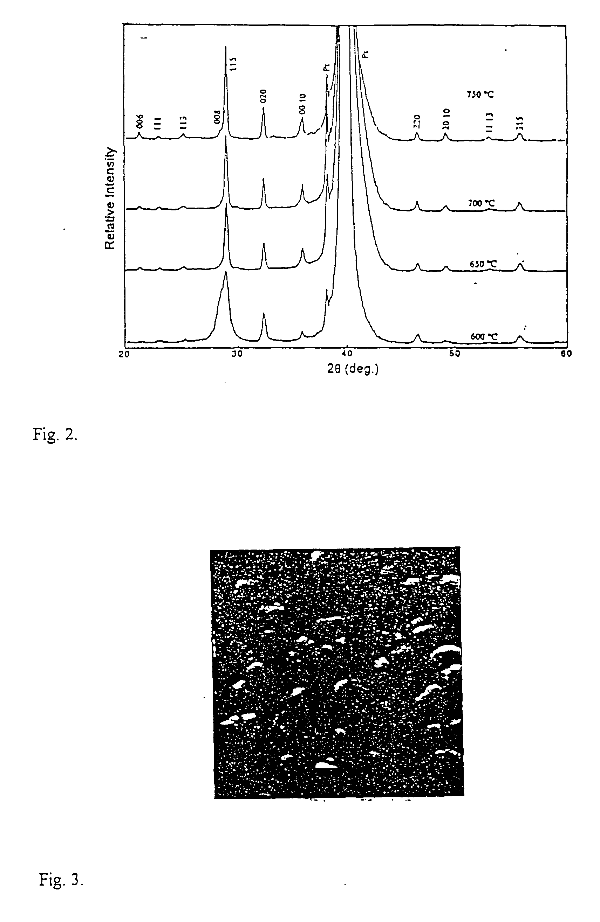

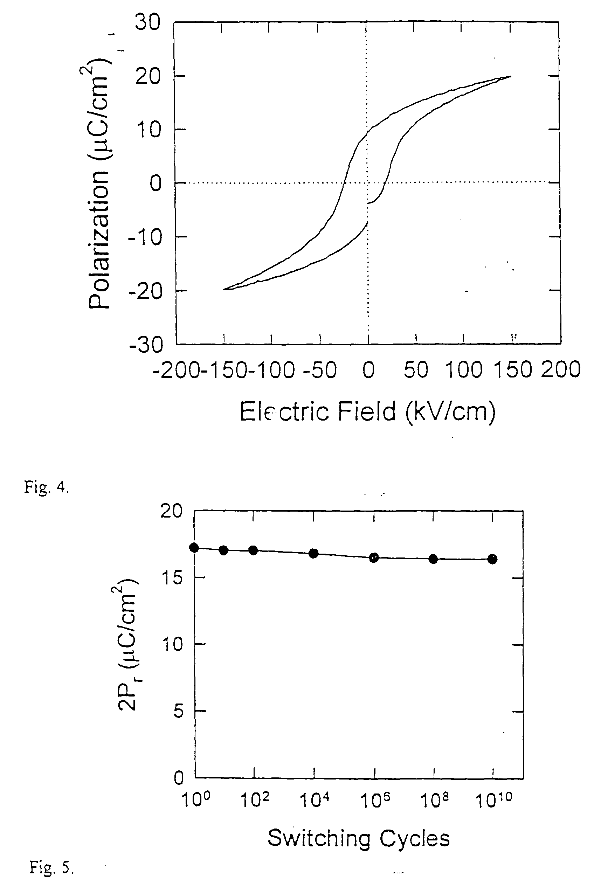

The films of SrBi₂Ta₂O₉ were fabricated by the chemical precursor solution technique using room temperature solution preparation procedure as described. For the preparation of SrBi₂Ta₂O₉, bismuth 2-ethylhexanoate, strontium acetate, and tantalum ethoxide were selected as precursors and acetic acid, 2-ethylhexanoic acid, and 2-methoxyethanol were selected as solvents. The selected precursors had high solubility in the corresponding solvents under ambient room temperature conditions. Bismuth 2-ethylhexanoate was dissolved in 2-ethylhexanoic acid, strontium acetate was dissolved in acetic acid, and a solution of tantalum ethoxide was formed in 2-methoxyethanol. Excess bismuth was added to account for the loss of bismuth during processing. The best results were obtained for 30 % excess bismuth. Then the various solutions were mixed together. The final solution was stable, clear, and transparent. The viscosity and surface tension of the solution was controlled by varying the 2-methoxyethanol content. The resulting films were annealed in the temperature range 600-750 °C in an oxygen atmosphere. Fig. 2 shows the x-ray diffraction patterns of the films. The films were found to be well crystallized at 650 °C with absence of any pyrochlore or secondary phases. As the annealing temperature was increased the peak intensity and sharpness in the x-ray diffraction pattern was found to increase indicating increase in grain sizes and crystallinity. Figure 3 shows the atomic force micrograph of the film annealed at 750 °C. The films exhibited a dense microstructure with no cracks or defects. The electrical characteristics were obtained on films in metal-ferroelectric film-metal (MFM) configuration. The MFM capacitors were prepared by depositing platinum electrodes through a mask on the top surface of the film by sputtering. The bottom platinum electrode was accessed by etching the film. The dielectric constant of the film annealed at 750 °C was found to be 330 at a frequency of 100 kHz. Figure 4 shows the P-E hysteresis loop for the film annealed at 750 °C. A remanent polarization (2Pᵣ) value of 17.2 *µ*C/cm² and a coercive field value of 23 kV/cm was obtained for SrBi₂Ta₂O₉ thin films. The films showed good switching endurance, as shown in Fig. 5, under bipolar stressing at least up to 10¹⁰ switching cycles.

### EXAMPLE 2(1-x)SrBi₂Ta₂O₉-xBi₃TiTaO₉ thin films

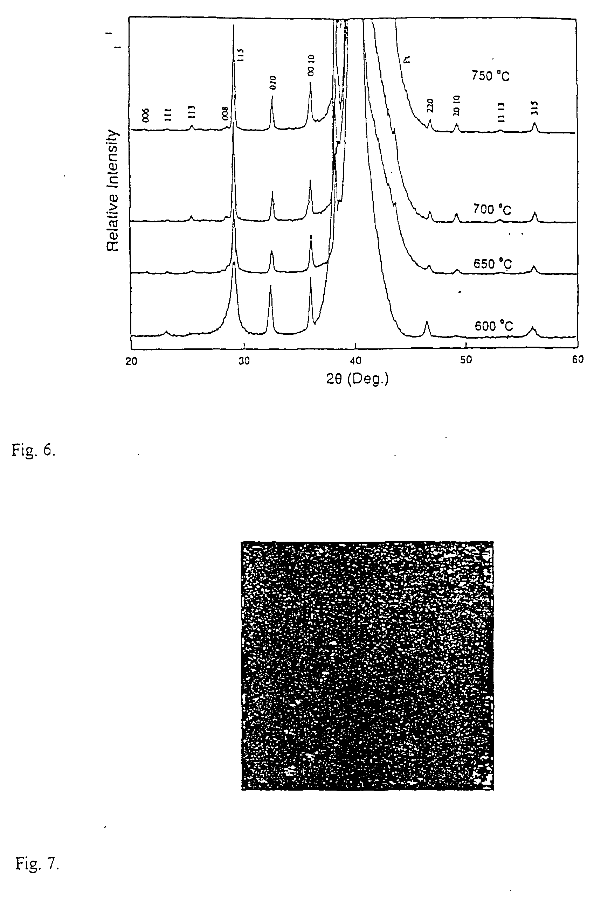

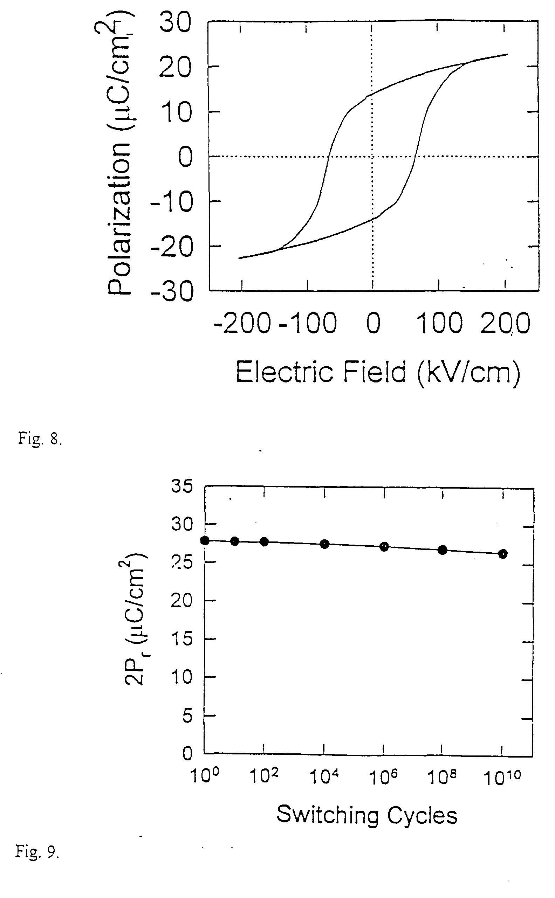

For the preparation of (1-x)SrBi₂Ta₂O₉-xBi₃Ti TaO₉ thin films, bismuth 2-ethylhexanoate, strontium acetate, titanium isopropoxide, and tantalum ethoxide were selected as precursors and acetic acid, 2-ethylhexanoic acid, and 2-methoxyethanol were selected as solvents. The selected precursors had high solubility in the corresponding solvents under ambient room temperature conditions. Bismuth 2-ethylhexanoate was dissolved in 2-ethylhexanoic acid, strontium acetate was dissolved in acetic acid, and a solution of tantalum ethoxide and titanium isopropoxide was formed in 2-methoxyethanol. Excess bismuth was added into the solution to account for bismuth loss during processing. Then the various solutions were mixed together. The final solution was stable, clear, and transparent. The viscosity and surface tension of the solution was controlled by varying the 2-methoxyethanol content. The present films, 0.7SrBi₂Ta₂O₉-0.3Bi₃TiTaO₉ composition, were annealed in the temperature range 600-750 °C in an oxygen atmosphere. Fig. 6 shows the x-ray diffraction patterns of the films. The films were found to be well crystallized at 600 °C with absence of any pyrochlore or secondary phases. As the annealing temperature was increased the peak intensity and sharpness in the x-ray diffraction pattern was found to increase indicating increase in grain sizes and crystallinity. Figure 7 shows the atomic force micrograph of the film annealed at 750 °C. The films exhibited a dense microstructure with no cracks or defects. The grain size was found to be much improved compared to SrBi₂Ta₂O₉ films annealed under similar conditions (Fig. 3). The electrical characteristics were obtained on films in metal-ferroelectric film-metal (MFM) configuration. The MFM capacitors were prepared by depositing platinum electrodes through a mask on the top surface of the film by sputtering. The bottom platinum electrode was accessed by etching the film. The dielectric constant of the film annealed at 750 °C was found to be 200 at a frequency of 100 kHz. Figure 8 shows the P-E hysteresis loop for the film annealed at 750 °C. A remanent polarization (2Pᵣ) value of 27.8 *µ*C/cm² and a coercive field value of 68 kV/cm was obtained for 0.7SrBi₂Ta₂O₉-0.3Bi₃TiTaO₉ thin films. The films annealed at 650 °C also exhibited much improved ferroelectric properties compared to SrBi₂Ta₂O₉ thin films (Table 1). The low temperature processing is desired as it will help in the selection of a suitable barrier layer for the memory device. The 2Pᵣ value was found to be significantly improved for the solid solution (Table 1). The films showed good switching endurance, as shown in Fig. 9, under bipolar stressing at least up to 10¹⁰ switching cycles.

### EXAMPLE 3(1-x)SrBi₂Ta₂O₉-xBi₃TiNbO₉ thin films

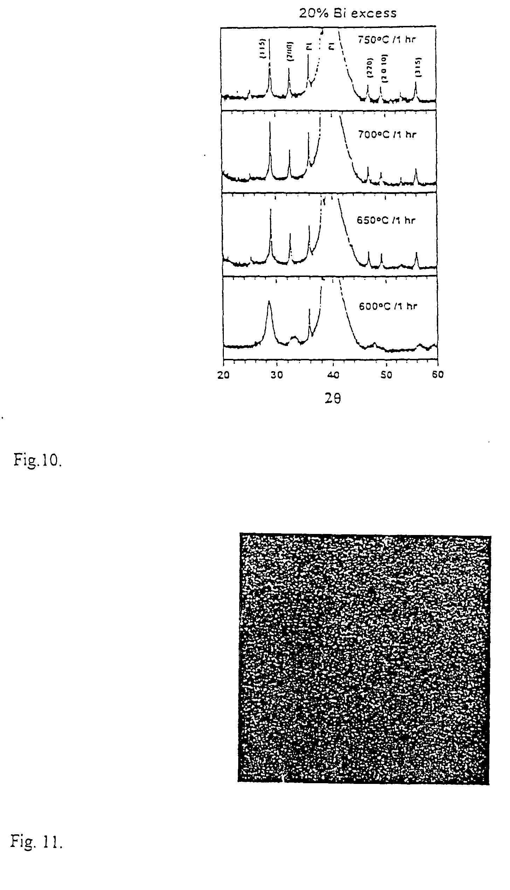

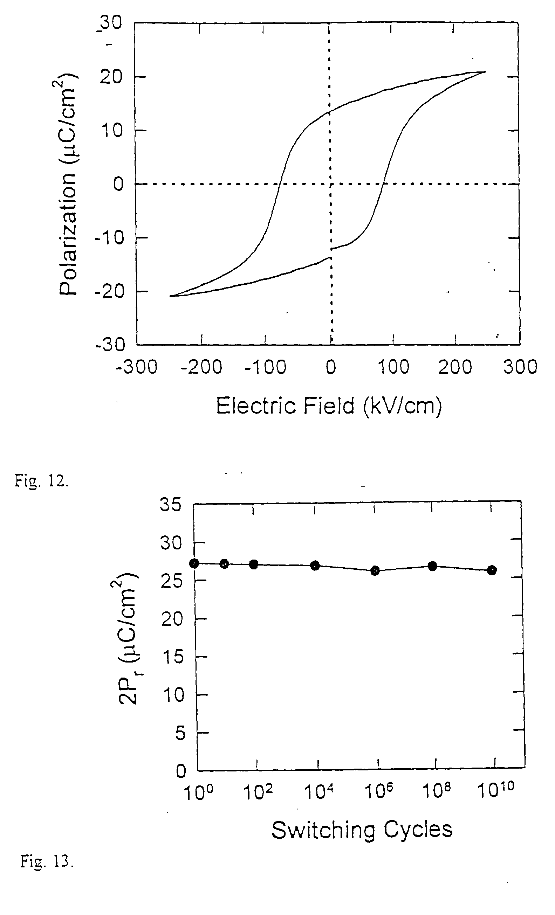

For the preparation of (1-x)SrBi₂Ta₂O₉-xBi₃TiNbO₉ thin films, bismuth 2-ethylhexanoate, strontium acetate, titanium isopropoxide, tantalum ethoxide, and niobium ethoxide were selected as precursors and acetic acid, 2-ethylhexanoic acid, and 2-methoxyethanol were selected as solvents. The selected precursors had high solubility in the corresponding solvents under ambient room temperature conditions. Bismuth 2-ethylhexanoate was dissolved in 2-ethylhexanoic acid, strontium acetate was dissolved in acetic acid, and a solution of niobium ethoxide, tantalum ethoxide, and titanium isopropoxide was formed in 2-methoxyethanol. Excess bismuth was added into the solution to account for bismuth loss during processing. Then the various solutions were mixed together. The final solution was stable, clear, and transparent. The viscosity and surface tension of the solution was controlled by varying the 2-methoxyethanol content. The present films, 0.8SrBi₂Ta₂O₉-0.2Bi₃TiNbO₉ composition, were annealed in the temperature range 600-750 °C in an oxygen atmosphere. Fig. 10 shows the x-ray diffraction patterns of the films. The films were found to be well crystallized at 600 °C with absence of any pyrochlore or secondary phases. As the annealing temperature was increased the peak intensity and sharpness in the x-ray diffraction pattern was found to increase indicating increase in grain sizes and cryst Hinity. Figure 11 shows the atomic force micrograph of the film annealed at 750 °C. The films exhibited a dense microstructure with no cracks or defects. The grain size was found to be much improved compared to SrBi₂Ta₂O₉ films annealed under similar conditions (Fig. 3). The electrical characteristics were obtained on films in metal-ferroelectric film-metal (MFM) configuration. The MFM capacitors were prepared by depositing platinum electrodes through a mask on the top surface of the film by sputtering. The bottom platinum electrode was accessed by etching the film. The dielectric constant of the film annealed at 750 °C was found to be 200 at a frequency of 100 kHz. Figure 12 shows the P-E hysteresis loop for the film annealed at 750 °C. A remanent polarization (2Pᵣ) value of 26.9 *µ*C/cm² and a coercive field value of 68 kV/cm was obtained for 0.8SrBi₂Ta₂O₉-0.2Bi₃TiNbO₉ thin films. The films annealed at 650 °C also exhibited much improved ferroelectric properties compared to SrBi₂Ta₂O₉ thin films (Table 1). The 2Pᵣ value was found to be significantly improved for the solid solution (Table 1). The films showed good switching endurance, as shown in Fig. 13, under bipolar stressing at least up to 10¹⁰ switching cycles. The following table shows experimental results of the above examples, demonstrating improved ferroelectric properties.

**Table 1.**

| Improved Polarization for the novel solid solution material compared to SBT. | | | |
|---|---|---|---|
| Temperature (°C) | SrBi₂Ta₂O₉ thin films 2 Pᵣ (µC/cm²) | 0.7SrBi₂Ta₂O₉-0.3Bi₃TiTaO₉ thin films 2 Pᵣ (µC/cm²) | 0.8SrBi₂Ta₂O₉-0.2Bi₃TiNbO₉, thin films 2 pᵣ (µC/cm²) |
| 650°C | 4.4 | 12.4 | 12.1 |
| 750 °C | 17.2 | 27.8 | 26.9 |

## Claims

1. A method of forming a film of layered perovskite material, comprising the steps of
(a) dissolving bismuth 2-ethylhexanoate in a first solvent to form a first solution;
(b) dissolving strontium acetate in a second solvent to form a second solution;
(c) dissolving titanium isopropoxide and tantalum ethoxide in a third solvent to form a third solution;
(d) mixing together the solutions formed in steps (a), (b) and (c) to form a homogenous mixed solution, steps of (a), (b), (c) and (d) being carried out at ambient temperature; and
(e) depositing the homogenous mixed solution onto a substrate, thereby to form a film, of (1-x)SrBi₂TaO₉-xBi₃TiTaO₉.

2. A method of forming a film layered peroyskite material involving steps (a), (b) and (d) of claim 1, wherein a step (c) comprises dissolving titanium isopropoxide, tantalum ethoxide and niobium ethoxide in a third solvent to form a third solution and wherein a step (e) comprises depositing the homogenous mixed solution onto a substrate thereby to form a film of (1-x)SrBi₂Ta₂O₉xBi₃TiNbO₉.

3. A method according to any claim 1 or claim 2, further comprising the step of annealing the substrate and film at a temperature of 600-750°C.

4. A method according to any one of claims 1 to 3, wherein the first solvent is 2-ethylhexanoic acid, the second solvent is acetic acid, and the third solvent is 2-methoxyethanol.

5. A method according to any one of claims 1 to 4, wherein the amount of bismuth in step (a) is in a 30% stoichiometric excess.

6. A method according to any one of claims 1 to 5, further comprising the step of forming a top electrode and a bottom electrode, sandwiching the film, whereby a capacitor structure is formed.

## Patentansprüche

1. Verfahren zum Herstellen eines Perovskit-Schichtmaterials, das die folgenden Schritte aufweist:
(a) Auflösen von Bismut-2-Ethylhexanoat in einem ersten Lösungsmittel, um eine erste Lösung herzustellen;
(b) Auflösen von Strontiumacetat in einem zweiten Lösungsmittel, um eine zweite Lösung herzustellen;
(c) Auflösen von Titanisopropoxid und Tantalethoxid in einem dritten Lösungsmittel, um eine dritte Lösung herzustellen;
(d) Vermischen der in den Schritten (a), (b) und (c) hergestellten Lösungen, um ein homogenes Lösungsgemisch herzustellen, wobei die Schritte (a), (b), (c) und (d) bei Umgebungstemperatur ausgeführt werden; und
(e) Abscheiden des homogenen Lösungsgemischs auf einem Substrat, um dadurch einen Film aus (1-x)SrBi₂Ta₂O₉-xBi₃TiTaO₉ herzustellen.

2. Verfahren zum Herstellen eines Films aus einem Perovskit-Schichtmaterial mit den Schritten (a), (b) und (d) des Anspruchs 1, bei dem der Schritt (c) das Auflösen von Titanisopropoxid, Tantalethoxid und Niobethoxid in einem dritten Lösungsmittel umfasst, um eine dritte Lösung herzustellen, und bei dem ein Schritt (e) das Abscheiden des homogenen Lösungsgemischs auf einem Substrat umfasst, um dadurch einen Film aus (1-x)SrBi₂Ta₂O₉-xBi₃TiTaO₉ herzustellen.

3. Verfahren nach Anspruch 1 oder Anspruch 2, ferner mit dem Schritt des Brennens des Substrats und des Films bei einer Temperatur von 600-750°C.

4. Verfahren nach einem der Ansprüche 1 bis 3, bei dem das erste Lösungsmittel 2-Ethylcapronsäure ist, das zweite Lösungsmittel Essigsäure ist und das dritte Lösungsmittel 2-Methoxyethanol ist.

5. Verfahren nach einem der Ansprüche 1 bis 4, bei dem die Menge von Bismut im Schritt (a) mit einem Überschuss von 30% gegenüber der Stöchiometrie vorliegt.

6. Verfahren nach einem der Ansprüche 1 bis 5, ferner mit dem Schritt des Herstellens einer oberen und einer unteren Elektrode, die den Film einbetten, wodurch eine Kondensatorstruktur gebildet wird.

## Revendications

1. Procédé de formation d'un film en un matériau perovskite stratifié, comprenant les étapes de
(a) dissolution de 2-éthylhexanoate de bismuth dans un premier solvant pour former une première solution ;
(b) dissolution d'acétate de strontium dans un deuxième solvant pour former une deuxième solution ;
(c) dissolution d'isopropylate de titane et d'éthylate de tantale dans un troisième solvant pour former une troisième solution ;
(d) mélange les unes aux autres des solutions formées dans les étapes (a), (b) et (c) pour former une solution mixte homogène, les étapes (a), (b), (c) et (d) étant mises en oeuvre à la température ambiante ; et
(e) dépôt de la solution mixte homogène sur un substrat, de façon à former un film de (1-x)SrBi₂TaO₉-xBi₃TiTaO₉.

2. Procédé de formation d'un film en un matériau perovskite stratifié mettant en jeu les étapes (a), (b) et (d) de la revendication 1, dans lequel une étape (c) comprend la dissolution d'isopropylate de titane, d'éthylate de tantale et d'éthylate de niobium dans un troisième solvant pour former une troisième solution, et dans lequel une étape (e) comprend le dépôt de la solution mixte homogène sur un substrat de façon à former un film de (1-x) SrBi₂Ta₂O₉-xBi₃TiNbO₉.

3. Procédé selon la revendication 1 ou 2, qui comprend en outre l'étape de recuit du substrat et du film à une température de 600 à 750°C.

4. Procédé selon l'une quelconque des revendications 1 à 3, dans lequel le premier solvant est l'acide 2-éthylhexanoïque, le deuxième solvant est l'acide acétique et le troisième solvant est le 2-méthoxyéthanol.

5. Procédé selon l'une quelconque des revendications 1 à 4, dans lequel la quantité de bismuth dans l'étape(a) correspond à un excès stoechiométrique de 30 %.

6. Procédé selon l'une quelconque des revendications 1 à 5, qui comprend en outre l'étape de formation d'une électrode supérieure et d'une électrode inférieure, lesquelles prennent le film en sandwich, de façon à former une structure de condensateur.
